# EUROPÄISCHE PATENTSCHRIFT

(11) **EP 0 745 271 B1**
(45) Veröffentlichungstag und Bekanntmachung des Hinweises auf die Patenterteilung: **12.05.1999**
(21) Anmeldenummer: 95906895.8
(22) Anmeldetag: 01.02.1995
(51) Int. Cl.: H01L 21/762

(54) **VERFAHREN ZUR HERSTELLUNG EINES EINEM GRABEN BENACHBARTEN DIFFUSIONSGEBIETES IN EINEM SUBSTRAT**
PROCESS FOR PRODUCING A DIFFUSION REGION ADJACENT TO A RECESS IN A SUBSTRATE
PROCEDE PERMETTANT DE REALISER UNE ZONE DE DIFFUSION ADJACENTE A UNE TRANCHEE DANS UN SUBSTRAT

(30) Priorität: 15.02.1994 DE 4404757
(43) Veröffentlichungstag der Anmeldung: 04.12.1996
(73) Patentinhaber: SIEMENS AKTIENGESELLSCHAFT, 80333 München (DE)
(72) Erfinder: SCHWALKE, Udo, D-84431 Heldenstein (DE); SEBALD, Michael, D-91093 Hessdorf (DE); SCHELER, Ulrich, D-80809 München (DE)
(86) Internationale Anmeldenummer: DE9500123
(87) Internationale Veröffentlichungsnummer: WO9522173

(56) Entgegenhaltungen:
- EP-A- 0 073 942
- EP-A- 0 445 471
- US-A- 4 013 484
- US-A- 4 534 824
- US-A- 4 564 583
- US-A- 4 728 619
- IBM TDB, Bd. 27,Nr. 10A, März 1985 NEW-YORK, Seiten 5501-5504, 'SIDEWALL CHANNEL-STOP DOPING FOR DEEP-TRENCH ISOLATION OF FET DEVICES'

## Beschreibung

Für verschiedene Anwendungen ist es erforderlich, Gräben mit hohem Aspektverhältnis (Aspektverhältnis ist der Quotient aus Grabentiefe zu Grabenweite) und an die Gräben angrenzende Diffusionsgebiete in Substraten herzustellen, wobei Diffusionsgebiete unterschiedlichen Leitfahigkeitstyps herstellbar sein sollen.

Derartige Graben mit benachbarten Diffusionsgebieten werden zum Beispiel in der Smart-Power-Technologie auf SOI-Substraten benötigt. In der Smart-Power-Technologie werden komplexe Logikbauelemente mit Hochspannungs-Leistungsbauelementen monolithisch in einem Substrat integriert. Da die Logikbauelemente mit Spannungspegeln um 5 Volt betrieben werden, bei den Hochspannungs-Leistungsbauelementen jedoch Spannungen bis zu 500 Volt auftreten, ist eine elektrische Trennung der Hochspannungsbauelemente von den Logikbauelementen erforderlich.

Es ist bekannt (siehe zum Beispiel A. Nakagawa et al., ISPSD pp97-101, Tokyo 1990, N.Yasuhara et al, IEDM 1991, SIEHE 141-144) die Hoch- und Niederspannungsbauelemente durch dielektrische Isolation elektrisch vollstandig gegeneinander zu isolieren. Dazu werden die Bauelemente in einem SOI-Substrat realisiert. Ein SOI-Substrat umfaßt auf einer einkristallinen Siliziumscheibe eine isolierende Schicht aus SiO₂ und auf der isolierenden Schicht eine einkristalline Siliziumschicht, die die Oberflache des SOI-Substrats umfaßt. Die Bauelemente werden in der einkristallinen Siliziumschicht realisiert. Die isolierende Schicht des SOI-Substrats stellt die vertikale Isolation sicher, während die laterale Isolation der Bauelemente durch mit isolierendem Material gefüllte Gräben realisiert wird. Diese Graben reichen bis auf die Oberfläche der isolierenden Schicht. Sie umgeben das zu isolierende Bauelement in der einkristallinen Siliziumschicht vollständig. Zur Füllung der Gräben wird zum Beispiel die Seitenwand thermisch aufoxidiert und der verbleibende Zwischenraum mit Polysilizium aufgefüllt, rückgeätzt und anschließend an der Oberflache aufoxidiert. Die Grabenfüllung besteht dann aus einem Polysiliziumkern, der vollständig von Siliziumoxid eingeschlossen ist.

Aus N. Yasuhara et al, IEDM 1991, SIEHE 141 - 144 ist bekannt, daß sich das Schaltverhalten der Bauelemente beeinflussen läßt durch Diffusionsgebiete, die in der einkristallinen Siliziumschicht an einen Isolationsgraben angrenzend hergestellt werden. Diese Dotierung erfolgt zum Beispiel durch Ausdiffusion aus dotierten Gläsern wie Borsilikatglas oder Phosphorsilikatglas oder durch Ionenimplantation.

Da in der Smart-Power-Technologie Grabentiefen um 20 µm mit Aspektverhaltnissen von 5 bis 10 auftreten, ist es problematisch durch Ionenimplantation bei der Dotierung der Seitenwände der Isolationsgraben Diffusionsgebiete mit einer gleichförmigen, vorgebbaren Ausdehnung herzustellen.

Zur Herstellung von Isolationsgraben benachbarten Diffusionsgebieten wird daher vor der Auffüllung des Grabens ganzflächig eine dotierte Schicht aufgebracht. Durch Ausdiffusion aus dieser dotierten Schicht werden dem Graben benachbarte Diffusionsgebiete erzeugt. Die Oberflache des Substrats wird dabei zum Beispiel durch eine bei der Grabenatzung verwendete Grabenmaske geschützt.

In IBM TDB Band 27, No. 10A, März 1985, Seite 5001 bis 5004 ist vorgeschlagen worden, zur Isolation von Feldeffekttransistoren in CMOS-Schaltungen tiefe Graben zu verwenden, die mit isolierendem Material aufgefüllt sind und an die dotierte Gebiete angrenzen. Zur Isolation zwischen n-Kanal und p-Kanal-Transistoren müssen diese dotierten Gebiete vom entgegengesetzten Leitfähigkeitstyp dotiert sein. Zur Herstellung dotierter Gebiete an nur einer Seitenwand eines Isolationsgrabens ist vorgeschlagen worden, zunächst an beiden Seitenwänden des Isolationsgrabens dotierte Schichte zu bilden und dann unter Verwendung einer Maske aus Polyimid, die mit Hilfe einer Aluminiummaske strukturiert wird, eines der dotierten Schichten abzuätzen.

In US-A-4 534 824 ist vorgeschlagen worden, zur Bildung unterschiedlich dotierter Gebiete, die an verschiedene Flanken ein und desselben Grabens angrenzen, nacheinander zwei maskierte Implantationsschritte durchzuführen. Dabei wird jeweils die Flanke, in der im jeweiligen Schritt kein dotiertes Gebiet gebildet werden soll, von einer strukturierten Maskierschicht, zum Beispiel aus SiO₂, abgedeckt.

In US-A-4 728 619 ist vorgeschlagen worden, zur Herstellung von Channel Stopper Gebieten unterhalb von Feldisolationsstrukturen eine Implantation von Germanium und Phosphor oder Bor vorzunehmen. Die Anwesenheit des Germaniums verzögert die Diffusion des Bors und des Phosphors und erlaubt so die genaue Einstellung der Form des Channel Stoppers.

In US-A-4 564 583 ist vorgeschlagen worden, zur Vermeidung von Fehljustierungen zweier nacheinander gebildeten Photolackmasken, die zur Herstellung von Channel Stopp-Bereichen und Feldoxidstrukturen verwendet werden, eine Doppelschicht zu erzeugen, die einen Positiv-Photolack und einen Negativ-Photolack umfaßt. Die beiden Photolackschichten werden gemeinsam belichtet. Es wird zunächst die obere Photolackschicht entwickelt, die als Maske zur Implantation von Channel-Stopp-Bereichen verwendet wird. Anschließend wird dieser entfernt und die untere Photolackschicht entwickelt, die komplementär zur ersten Photolackmaske ist und die zur Strukturierung einer isolierenden Schicht verwendet wird.

In EP 0 445 471 A2 ist vorgeschlagen worden, zur Bildung flacher Isolationsgraben mit einem dem Graben benachbarten Diffusionsgebiet, in einem Substrat einen Graben zu ätzen. Anschließend wird ein Maskieroxid (Blockeroxid) aufgewachsen und so strukturiert, daß es den Bereich der Grabenwand abdeckt, dem kein Diffusionsgebiet benachbart sein soll. Durch selektive Epitaxie wird anschließend auf der freiliegenden Oberflache des Grabens eine dotierte Siliziumschicht aufgewachsen. Im Bereich des Maskieroxides wächst dabei wegen der Selektivität der Epitaxie kein dotiertes Silizium auf. Anschließend wird eine thermische Oxidation durchgeführt, mit der an den Seitenwänden der Gräben und am Boden der Gräben eine Grabenoxidschicht gebildet wird. Gleichzeitig diffundiert Dotierstoff aus der selektiv aufgewachsenen dotierten Siliziumschicht in die Seitenwand des Grabens und bildet ein dem Graben benachbartes Diffusionsgebiet.

In IBM TDB Band 27, No. 7B, Dezember 1984, Seite 4503 bis 4508 ist vorgeschlagen worden, ein einem Graben benachbartes Diffusionsgebiet dadurch zu bilden, daß nach der Grabenätzung eine SiO₂-Schicht an der Grabenwand abgeschieden und strukturiert wird, die als Maske bei der Dotierung des Diffusionsgebietes verwendet wird.

Aus Microelectronic Engineering Vol. 20, No. 4, Dezember 1993, Seite 305 bis 319, ist ein Mehrlagenphotolacksystem bekannt, dessen oberste Schicht durch Sililierung in ihrer Beständigkeit gegenüber einer O₂-Plasmaätzung verbessert werden kann.

Bei Grabentiefen und Aspektverhaltnissen, wie sie in der Smart-Power-Technologie auftreten, ist eine Strukturierung der dotierten Schicht mittels konventioneller Fotolacktechnik nicht möglich, da der Fotolack in einer Tiefe von 20 µm nicht durchbelichtet werden kann. Außerdem kommt es bei der Belichtung durch mangelnde Fokussierung und Lichtreflexionen im Lack zu weiteren Problemen. Daher können mit der bekannten Technik keine strukturierten Diffusionsgebiete mit unterschiedlichen Leitfähigkeitstyp hergestellt werden. Zur Herstellung von Schaltungen, in denen Gräben mit benachbarten Diffusionsgebieten unterschiedlichen Leitfahigkeitstyps erforderlich sind, erfolgt die Herstellung der Diffusionsgebiete unterschiedlichen Leitfahigkeitstyps in zwei Schritten. Zunächst werden diejenigen Gräben geätzt, in deren Seitenwanden Diffusionsgebiete eines ersten Leitfahigkeitstyps hergestellt werden sollen. Nach der Herstellung der Diffusionsgebiete werden die Gräben aufgefüllt. Dann werden unter Verwendung einer zweiten Grabenmaske diejenigen Gräben geätzt, in deren Seitenwänden Diffusionsgebiete eines zweiten Leitfähigkeitstyp hergestellt werden sollen. Nach Herstellung der zweiten Diffusionsgebiete werden auch diese Gräben aufgefüllt. Sollen darüber hinaus Gräben hergestellt werden, in deren Seitenwänden keine Diffusionsgebiete erzeugt werden, so ist eine weitere Grabenätzung mit anschließender Grabenfüllung erforderlich.

Der Erfindung liegt daher das Problem zugrunde, ein Verfahren zur Herstellung eines einem Graben benachbarten Diffusionsgebietes in einem Substrat anzugeben, mit dem innerhalb eines Grabens strukturierte Diffusionsgebiete realisierbar sind. Das Verfahren soll insbesondere geeignet sein zur Herstellung von Diffusionsgebieten unterschiedlichen Leitfahigkeitstyps, die ein und demselben Graben oder verschiedenen Gräben benachbart angeordnet sind.

Dieses Problem wird erfindungsgemäß gelöst durch ein Verfahren nach Anspruch 1. Weitere Ausgestaltungen der Erfindung gehen aus den übrigen Ansprüchen hervor.

In dem erfindungsgemäßen Verfahren wird nach Herstellung eines Grabens ganzflächig eine Diffusionsbarriereschicht aufgebracht. Die Diffusionsbarriereschicht wird unter Verwendung eines mindestens zwei Lagen umfassenden Mehrlagenphotolacksystems strukturiert. Auf die strukturierte Diffusionsbarriereschicht wird ganzflächig eine dotierte Schicht abgeschieden, die als Diffusionsquelle geeignet ist. Durch Ausdiffusion aus der dotierten Schicht wird dem Graben benachbart ein Diffusionsgebiet gebildet, wobei die strukturierte Diffusionsbarriereschicht unter der dotierten Schicht als Maske wirkt. Die Diffusionsbarriereschicht wird so ausgelegt, daß sie eine Diffusion des Dotierstoffs aus der dotierten Schicht in das Substrat verhindert. Vorzugsweise wird die Diffusionsbarriereschicht aus SiO₂ oder Si₃N₄ hergestellt. Als dotierte Schicht ist insbesondere dotiertes Polysilizium oder dotiertes Glas geeignet.

Zur Herstellung von Diffusionsgebieten unterschiedlichen Leitfahigkeitstyps wird zunächst eine erste Diffusionsbarriereschicht aufgebracht, die unter Verwendung eines mindestens zwei Lagen umfassenden Mehrlagenlacksystems strukturiert wird. Darauf wird eine erste dotierte Schicht abgeschieden, die als Diffusionsquelle zur Herstellung eines ersten Diffusionsgebietes verwendet wird. Nach der Herstellung des ersten Diffusionsgebietes wird die erste dotierte Schicht entfernt. Es wird eine zweite Diffusionsbarriereschicht ganz flächig aufgebracht. Unter Verwendung eines mindestens zwei Schichten umfassenden Mehrlagenlacksystems werden die zweite Diffusionsbarriereschicht und die darunter liegende erste Diffusionsbarriereschicht strukturiert. Dann wird ganzflächig eine zweite dotierte Schicht abgeschieden, die als Diffusionsquelle zur Bildung eines zweiten Diffusionsgebietes verwendet wird. Nach Entfernung der zweiten dotierten Schicht, der zweiten Diffusionsbarriereschicht und der ersten Diffusionsbarriereschicht erfolgt die weitere Prozessierung des Grabens, zum Beispiel durch Auffüllen mit SiO₂ und Polysilizium.

In Anwendungen, in denen die gleichzeitige Strukturierung der zweiten Diffusionsbarriereschicht und der ersten Diffusionsbarriereschicht infolge der inhomogenen Dicke zu einer Beschädigung der Oberfläche des Substrats führen könnte, wird vor dem Aufbringen der zweiten Diffusionsbarriereschicht die strukturierte erste Diffusionsbarriereschicht entfernt. In diesem Fall wird lediglich die zweite Diffusionsbarriereschicht im zweiten Strukuturierungsschritt strukturiert.

Auf diese Weise können unterschiedliche dotierte Diffusionsgebiete hergestellt werden, die in unterschiedlichen Gräben angeordnet sind, die an verschiedenen Seitenwänden eines Grabens angeordnet sind, die nebeneinander an einer Seitenwand eines Grabens angeordnet sind und auch solche, die sich überlappen. Mit dem erfindungsgemäßen Verfahren ist zur Herstellung von Diffusionsgebieten unterschiedlichen Leitfähigkeitstyp lediglich eine Grabenätzung erforderlich. Die Gräben können, nachdem auf erfindungsgemaße Weise Diffusionsgebiete hergestellt sind, in einem Schritt gefüllt und weiterprozessiert werden. Dadurch wird der Prozeßaufwand deutlich reduziert.

Zur Strukturierung der Diffusionsbarriereschichten sind alle Mehrlagenfotolacksysteme geeignet, die eine Planarisierung der Struktur bewirken und bei denen die fotolithographische Sturkturierung in der obersten Schicht an der Oberfläche erfolgt. Derartige Lacksysteme sind zum Beispiel aus M. Sebald et al, SPIE Vol. 1262, pp. 528 - 537 (1990) oder H. Ahne et al, Siemens Review, R & D Specials, pp. 23 -27 (1991) bekannt.

Zur Strukturierung der Diffusionsbarriereschichten wird vorzugsweise eine Bottomresistschicht aufgebracht, die durch Ausheizen lichtundurchlässig gemacht wird. Dazu ist zum Beispiel ein Fotolack auf Diazochinon/Novolak-Basis geeignet. Bei Blasenbildung im Bottomresist kann durch planarisierendes Rückätzen und wiederholtes Belacken ein ausreichender Planarisierungsgrad sichergestellt werden. Um eine Blasenbildung in der Bottomresistschicht im Graben vollständig zu vermeiden, ist es vorteilhaft, den Fotolack bei reduziertem Druck, gegebenenfalls im Vakuum, aufzubringen.

Auf die Bottomresistschicht wird eine Topresistschicht aufgebracht, die belichtet und entwickelt wird. Unter Verwendung der entwickelten Topresistschicht als Maske wird die Bottomresistschicht in einem anisotropen Ätzprozeß geätzt. Für die Topresistschicht wird vorzugsweise ein siliziumhaltiges Terpolymer, das aus den Monomeren Maleinanhydrid, Allyltrimethylsilan und Maleinimid aufgebaut ist, verwendet. In diesem Fall wird die Bottomresistschicht vorzugsweise in einem O₂-Plasma strukturiert. Dabei kommt es durch Reaktion des O₂ aus dem Plasma und des Silizium aus der Topresistschicht zur Bildung von SiO₂, das die Topresistschicht vor dem O₂-Plasmaangriff schützt. Eine weiter erhöhte Beständigkeit der Topresistschicht gegenüber der O₂-Plasmaätzung wird erreicht, wenn der unbelichtete Teil der Topresistschicht vor der Strukturierung der Bottomresistschicht an der Oberfläche durch eine Behandlung mit einem Aminosiloxan silyliert wird.

Im folgenden wird die Erfindung anhand der Figuren und eines Ausführungsbeispiels näher erläutert.
- Figur 1: zeigt ein SOI-Substrat mit einer Grabenmaske.
- Figur 2: zeigt das SOI-Substrat nach der Grabenätzung und nach der Abscheidung einer ersten Diffusionsbarriereschicht.
- Figur 3: zeigt das SOI-Substrat nach dem Aufbringen der Bottomresistschicht und der Topresistschicht.
- Figur 4: zeigt die Belichtung der Topresistschicht.
- Figur 5: zeigt das SOI-Substrat nach Entwicklung der Topresistschicht.
- Figur 6: zeigt das SOI-Substrat nach Silylierung der Topresistschicht.
- Figur 7: zeigt das SOI-Substrat nach Strukturierung der Bottomresistschicht und der ersten Diffusionsbarriereschicht.
- Figur 8: zeigt das SOI-Substrat nach Aufbringen einer dotierten Schicht und die Herstellung eines ersten Diffusionsgebietesiehe
- Figur 9: zeigt das SOI-Substrat nach Aufbringen einer zweiten Diffusionsbarriereschicht, einer Bottomresistschicht und einer Topresistschicht.
- Figur 10: zeigt die Belichtung der Topresistschicht.
- Figur 11: zeigt das SOI-Substrat nach der Strukturierung der Bottomresistschicht.
- Figur 12: zeigt das SOI-Substrat nach der Strukturierung der zweiten Diffusionsbarriereschicht und der ersten Diffusionsbarriereschicht.
- Figur 13: zeigt das SOI-Substrat nach Abscheidung einer zweiten dotierten Schicht und Herstellung eines zweiten Diffusionsgebietesiehe
- Figur 14: zeigt das SOI-Substrat nach Entfernung der zweiten dotierten Schicht und der Diffusionsbarriereschichten.

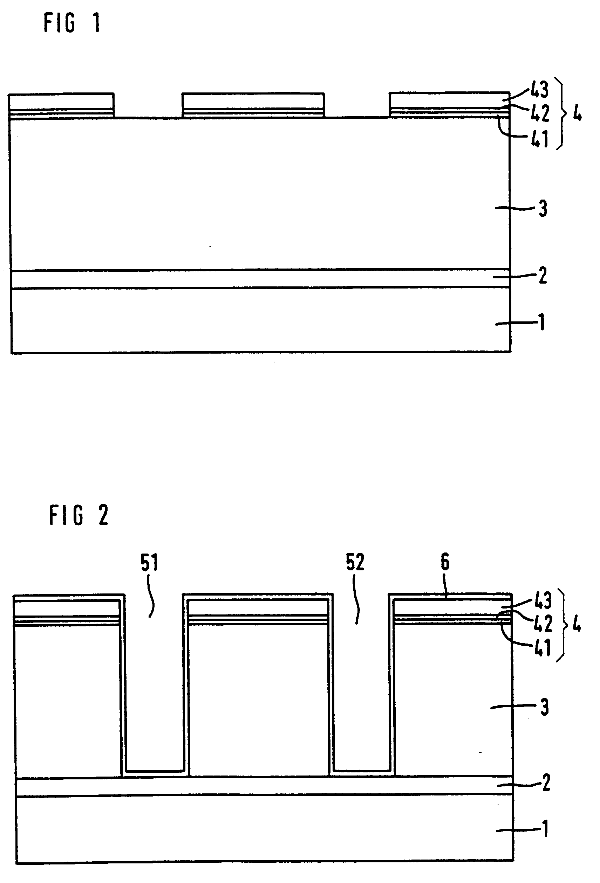

Auf ein SOI-Substrat, das eine monokristalline Siliziumscheibe 1, eine isolierende Schicht 2 aus SiO₂ und eine monokristalline Siliziumschicht 3 umfaßt, wird eine Grabenmaske 4 aufgebracht (siehe Figur 1). Die isolierende Schicht 2 weist eine Dicke von 2 µm auf. Die monokristalline Siliziumschicht 3 weist eine Dicke von 20 µm auf und ist zum Beispiel schwach n-dotiert.

Das SOI-Substrat ist vorzugsweise nach dem direct wafer bonding (DWB) oder silicon direct bonding (SDB)-Verfahren, das zum Beispiel aus Yu Ohata et al, IEEE 1987, Seite 443- 446 bekannt ist, hergestellt wird.

Die Grabenmaske 4 umfaßt eine untere Schicht 41, eine mittlere Schicht 42 und eine obere Schicht 43. Die untere Schicht 41 wird zum Beispiel durch thermische Oxidation in einer Dicke von 50 nm hergestellt. Die mittlere Schicht 42 wird zum Beispiel durch CVD-Abscheidung von Si₃N₄ in einer Dicke von 150 nm hergestellt. Die obere Schicht 43 wird zum Beispiel durch CVD-Abscheidung von SiO₂ in einr Dicke von 1600 nm hergestellt. Zur Strukturierung der Grabenmaske 4 wird auf diese Schichtenfolge eine Lackmaske aufgebracht. Die Grabenmaske 4 wird mit Hilfe der Lackmaske in einem CHF₃/O₂-Trockenätzprozeß strukturiert. Die Grabenmaske 4 muß zum Ätzen eines tiefen Grabens geeignet sein.

Nach Entfernen der Lackmaske zum Beispiel durch Lackstrippen werden mit Hilfe der Grabenmaske 4 tiefe Gräben 51, 52 in die monokristalline Siliziumschicht 3 geätzt. Dazu wird ein anisotroper Trockenätzprozes mit Cl₂/O₂-Chemie verwendet. Die Grabenätzung erfolgt selektiv zu SiO₂ und stopt daher, sobald die Oberfläche der isolierenden Schicht 2 freigelegt ist (siehe Figur 2). Nach Entfernen der Ätzprodukte zum Beispiel in einem HF-Dip wird ganz flächig eine erste Diffusionsbarriereschicht 6 aufgebracht. Die erste Diffusionsbarriereschicht 6 wird zum Beispiel durch CVD-Abscheidung von SiO₂ oder Si₃N₄ in einer Dicke von 50 nm hergestellt.

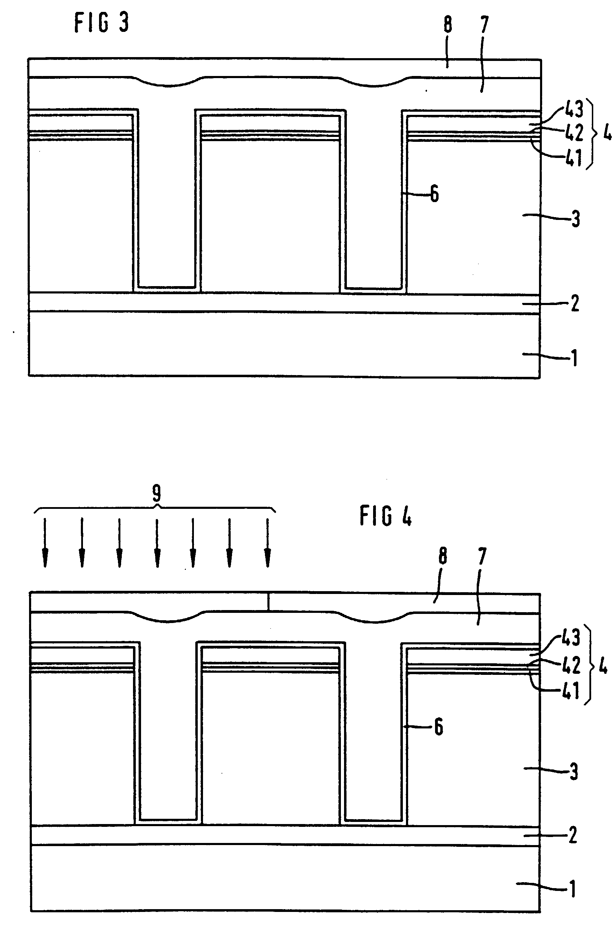

Zur Strukturierung der ersten Diffusionsbarriereschicht 6 wird ganzflächig eine Bottomresistschicht 7 aufgebracht. Die Bottomresistschicht 7 wird zum Beispiel aus TMSR-Fotolack in einer Dicke von 2 µm aufgebracht. Die Bottomresistschicht 7 wird planarisiert und anschließend ausgeheizt, so daß sie lichtundurchlässig wird. Das bewirkt eine Reduktion von Reflexionen (siehe Figur 3). Auf die Bottomresistschicht 7 wird eine Topresistschicht 8 aufgebracht, die weiter planarisiert. Als Topresistschicht 8 wird zum Beispiel ein siliziumhaltiges Terpolymer, das aus dem monomeren Maleinanhydrid, Allyltrimethylsilan und Maleinimid aufgebaut ist, verwendet.

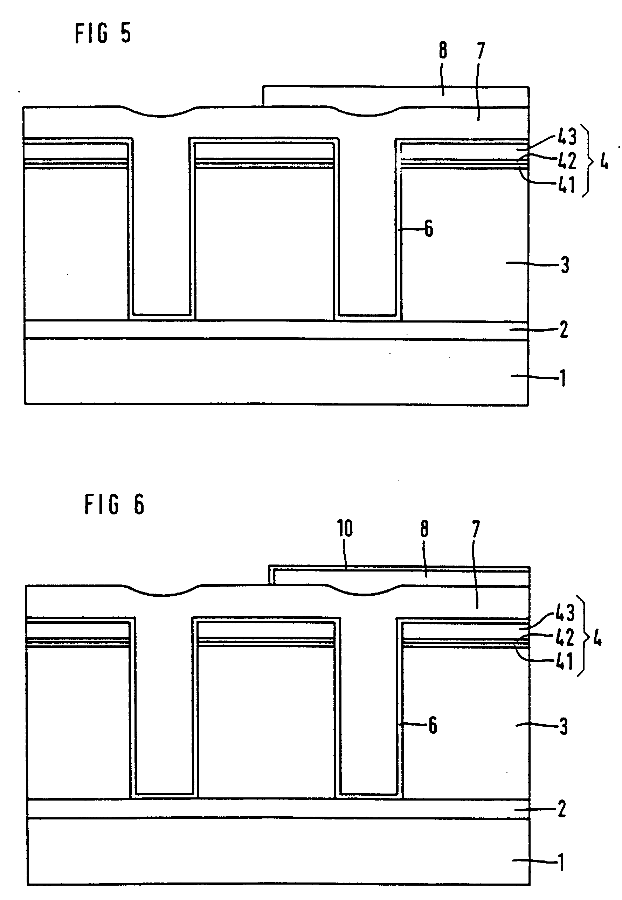

Die Topresistschicht 8 wird mit Licht, in Figur 4 als Pfeile 9 angedeutet, belichtet. Durch Entwickeln des belichteten Teils der Topresistschicht 8 wird in diesem Bereich der Oberflache der Bottomresistschicht 7 freigelegt (siehe Figur 5).

Der unbelichtete Teil der Topresistschicht 8 wird an der Oberfläche durch Einwirkung von Aminosiloxan silyliert. Dadurch bildet sich an der Oberfläche der Topresistschicht 8 eine Schutzschicht 10, die die Beständigkeit gegenüber einer O₂-Plasmaätzung erhöht (siehe Figur 6).

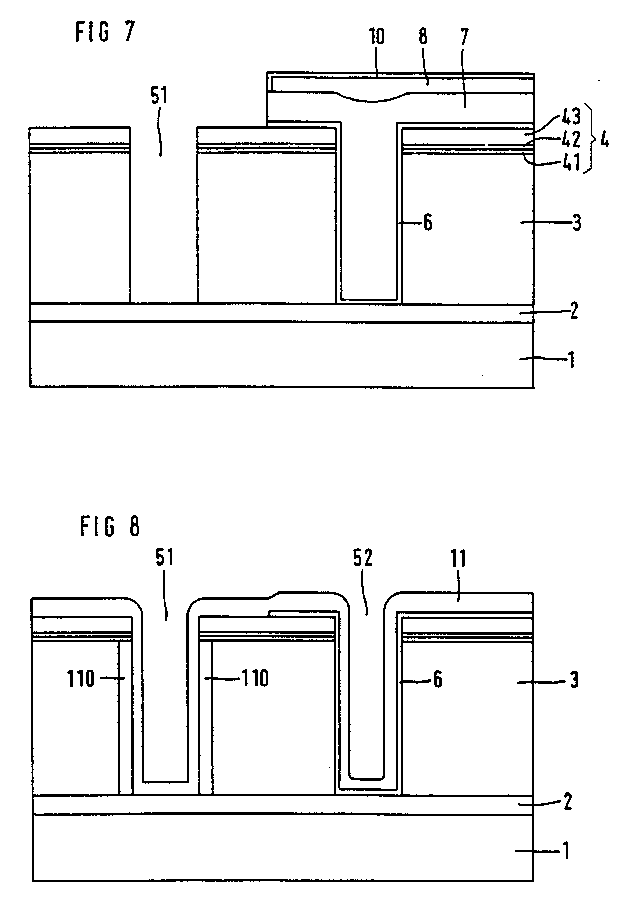

Der freiliegende Teil der Bottomresistschicht 7 wird anschließend anisotrop in einem O₂-Plasma geätzt. Die O₂-Plasmaätzung ist selektiv zu SiO₂ sowie Si₃N₄, so daß die Ätzung auf der ersten Diffusionsbarriereschicht 6 stopt. Die erste Diffusionsbarriereschicht 6 wird anschließend in einem isotropen Naßätzprozeß, zum Beispiel durch HF-Dip geätzt (siehe Figur 7). Dabei wird sowohl die Oberfläche der Grabenmaske 4 als auch die Seitenwände des ersten Grabens 51 sowie der Boden des ersten Grabens 51 freigelegt.

Die Schutzschicht 10, der Rest der Topresistschicht 8 und der Rest der Bottomresistschicht 7 werden entfernt. Anschließend wird ganzflächig eine dotierte Schicht 11 aufgebracht, die als Diffusionsquelle geeignet ist (siehe Figur 8). Die dotierte Schicht 11 wird zum Beispiel aus Borsilikatglas abgeschieden. Im Bereich des ersten Grabens 51 liegt die dotierte Schicht 11 direkt auf der Oberfläche der monokristallinen Siliziumschicht 3 auf. Im Bereich des zweiten Grabens 52 dagegen ist die Oberfläche der monokristallinen Schicht 3 von der ersten Diffusionsbarriereschicht 6 bedeckt. Die dotierte Schicht 11 liegt in diesem Bereich auf der ersten Diffusionsbarriereschicht 6 auf. In einem Temperschritt bei zum Beispiel 1000 °C während 30 Minuten in N₂-Atmosphäre werden erste Diffusionsgebiete 110, die dem ersten Graben 51 benachbart sind, durch Eintreiben von Dotierstoff gebildet. Im Bereich des zweiten Grabens 52 verhindert die erste Diffusionsbarriereschicht 6 ein Eindringen des Dotierstoffs in das Substrat.

Nach dem Temperschritt wird die erste dotierte Schicht 11 entfernt.

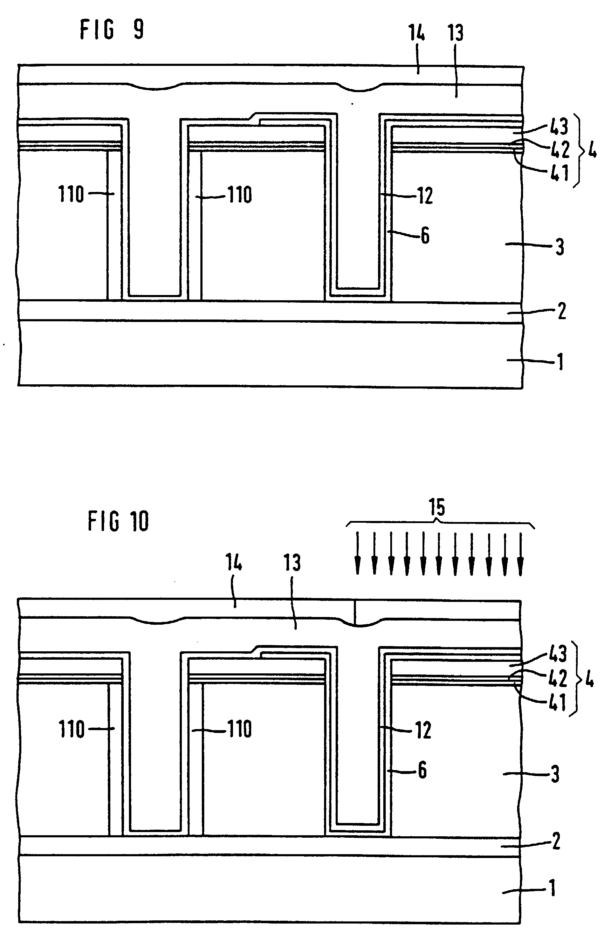

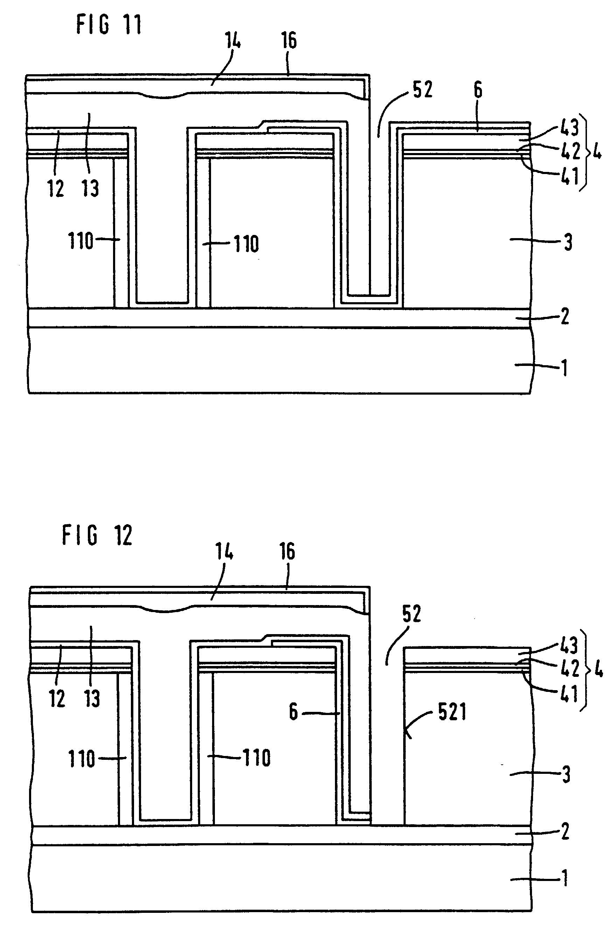

Es wird ganz flächig eine zweite Diffusionsbarriereschicht 12 zum Beispiel durch CVD-Abscheidung von SiO₂ oder Si₃N₄ in einer Dicke von zum Beispiel 50 nm abgeschieden. Darauf wird eine weitere Bottomresistschicht 13 aus zum Beispiel TMSR-Fotolack in einer Dicke von 2 µm aufgebracht und planarisiert. Die weitere Bottomresistschicht 13 wird ausgeheizt, so daß sie lichtundurchlässig wird. Darauf wird eine weitere Topresistschicht 14 aufgebracht und planarisiert. Die weitere Topresistschicht 14 wird zum Beispiel aus CARL-Lack gebildet, einem siliziumhaltigen Terpolymer, das aus den monomeren Maleinanhydrid, Allyltrimethylsilan und Maleinimid aufgebaut ist (siehe Figur 9). Die weitere Topresistschicht 14 wird lokal belichtet. Die Belichtung ist in Figur 10 als Pfeile 15 angedeutet. Der belichtete Teil der weiteren Topresistschicht 14 wird entwickelt, wobei die Oberfläche der weiteren Bottomresistschicht 13 in diesem Bereich freigelegt wird. Zur Erhöhung der Beständigkeit gehen über O₂-Plasmaätzung wird die Oberfläche des unbelichteten Teils der weiteren Topresistschicht 14 mit einem Aminosiloxan silyliert. Dadurch wird eine weitere Schutzschicht 16 an der Oberfläche der weiteren Topresistschicht 14 gebildet. Der freiliegende Teil der weiteren Bottomresistschicht 13 wird anisotrop in einem O₂-Plasma geätzt (siehe Figur 11).

Nachfolgend wird in einem isotropen Naßätzprozeß, zum Beispiel in einem HF-Dip, (bei einer SiO₂-Barriere) die zweite Diffusionsbarriereschicht 12 und die darunterliegenden Anteile der ersten Diffusionsbarriereschicht 6 geätzt. Die isotrope Naßätzung erfolgt selektiv zu Silizium (siehe Figur 12). Durch die Sturkturierung der zweiten Diffusionsbarriereschicht 12 und der ersten Diffusionsbarriereschicht 6 wird im Bereich des zweiten Grabens 52 eine Seitenwand 521 freigelegt. Die gegenüberliegende Seitenwand bleibt von der ersten Diffusionsbarriereschicht 6 und der zweiten Diffusionsbarriereschicht 12 bedeckt. Die Seitenwände des ersten Grabens 51 sind von der zweiten Diffusionsbarriereschicht bedeckt.

In Fällen, in denen der bei der Naßätzung zu entfernende Teil der zweiten Diffusionsbarriereschicht teils auf der ersten Diffusionsbarriereschicht angeordnet ist, teils auf der Unterlage angeordnet ist und in denen deshalb die Dicke des zu ätzenden Materials inhomogen ist, kann, wenn bei der isotropen Naßätzung eine Beschädigung der Unterlage durch Überätzen befürchtet wird, die erste Diffusionsbarriereschicht 6 vor dem ganzflächigen Aufbringen der zweiten Diffusionsbarriereschicht 12 entfernt werden.

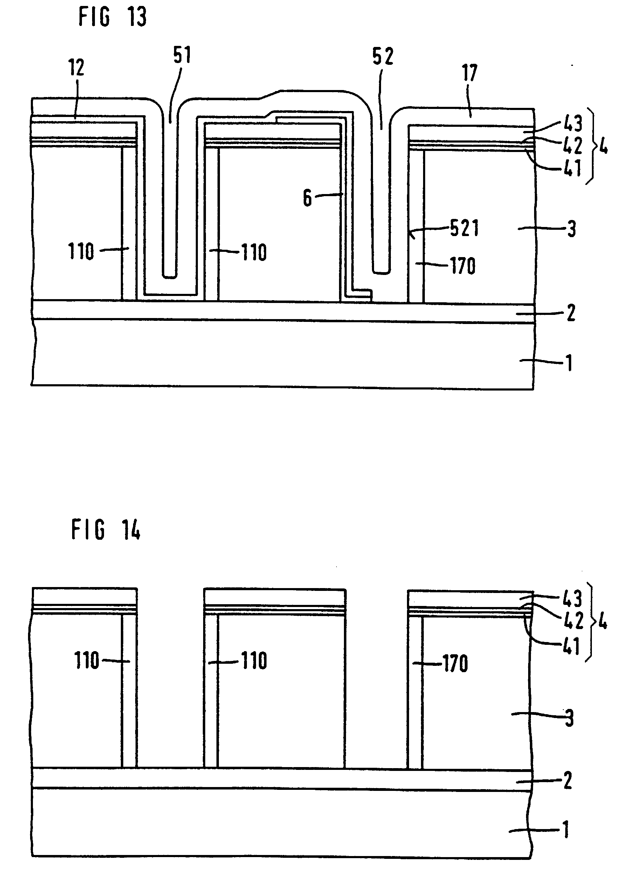

Nach Entfernen der weiteren Schutzschicht 16, der weiteren Topresistschicht 14 und der weiteren Bottomresistschicht 13 wird ganzflächig eine zweite dotierte Schicht 17 aufgebracht, die als Diffusionsquelle geeignet ist. Die zweite dotierte Schicht 17 wird zum Beispiel durch Abscheidung von Phosphorsilikatglas gebildet (siehe Figur 13). Nur entlang der Seitenwand 521 des zweiten Grabens 52 liegt die zweite dotierte Schicht 17 unmittelbar auf der monokristallinen Siliziumschicht 3 auf. Im übrigen Bereich ist zwischen der zweiten dotierten Schicht 17 und der monokristallinen Siliziumschicht 3 die zweite Diffusionsbarriereschicht 12 bzw. die erste Diffusionsbarriereschicht 6 und die zweite Diffusionsbarriereschicht 12 angeordnet.

In einem Temperschritt bei zum Beispiel 1000 °C während 30 Minuten in N₂-Atmosphäre wird durch Eintreiben des Dotierstoffes ein zweites dotiertes Gebiet 170 entlang der Seitenwand 521 des zweiten Grabens 52 gebildet. Die erste Diffusionsbarriereschicht 6 und die zweite Diffusionsbarriereschicht 12 verhindern ein Eindringen des Dotierstoffes außerhalb der Seitenwand 521.

Mit dem erfindungsgemaßen Verfahren ist es auch möglich, durch entsprechende Strukturierung der ersten und der zweiten Diffusionsbarriereschicht nur Teile von Seitenwänden eines Grabens mit einem Diffusionsgebiet zu versehen. Es ist ferner möglich, in einer Seitenwand benachbarte oder überlappende Diffusionsgebiete unterschiedlichen Leitfahigkeitstyps herzustellen.

Die zweite dotierte Schicht 17, die zweite Diffusionsbarriereschicht 12 und die erste Diffusionsbarriereschicht 6 werden zum Beispiel durch naßchemisches Ätzen mit HF-Dip bei SiO₂-Barriere oder H₃PO₄ bei Si₃N₄-Barriere entfernt (siehe Figur 14).

Anschließend werden die Gräben 51, 52 zum Beispiel durch Abscheidung von SiO₂ und Polysilizium gefüllt. In der monokristallinen Schicht 3 werden dann die für die Schaltung erforderlichen Bauelemente realisiert (nicht dargestellt). Zu isolierende Bauelemente sind in der monokristallinen Schicht 3 jeweils ringförmig vollständig von einem Graben umgeben.

## Patentansprüche

1. Verfahren zur Herstellung mindestens eines einem Graben benachbarten Diffusionsgebietes in einem Substrat,
- bei dem in das Substrat (1, 2, 3), das mindestens an der Oberfläche Silizium aufweist, mindestens ein Graben (51), der im wesentlichen senkrecht zur Oberfläche des Substrats (1, 2, 3) verläuft, geätzt wird,
- bei dem ganzflächig eine Diffusionsbarriereschicht (6) aufgebracht wird,
- bei dem die Diffusionsbarriereschicht (6) unter Verwendung eines mindestens zwei Schichten (7, 8) umfassenden Mehrlagenfotolacksystems strukturiert wird,
- bei dem zur Strukturierung der Diffusionsbarriereschicht (6) eine Bottomresistschicht (7) aufgebracht wird, die durch Ausheizen lichtundurchlässig gemacht wird,
- bei dem eine Topresistschicht (8) aufgebracht wird, die belichtet und entwickelt wird,
- bei dem unter Verwendung der entwickelten Topresistschicht (8, 10) als Maske die Bottomresistschicht (7) in einem anisotropen Trockenätzprozeß geätzt wird,
- bei dem nach dem Strukturieren der Diffusionsbarriereschicht (6) Bottomresistschicht (7) und Topresistschicht (8) entfernt werden.
- bei dem ganzflächig eine dotierte Schicht (11) abgeschieden wird, die als Diffusionsquelle geeignet ist,
- bei dem das Diffusionsgebiet (110) durch Ausdiffusion aus der dotierten Schicht (11) gebildet wird, wobei die strukturierte Diffusionsbarriereschicht (6) unter der dotierten Schicht (11) als Maske wirkt.

2. Verfahren nach Anspruch 1,
- bei dem ganz flächig eine erste Diffusionsbarriereschicht (6) aufgebracht wird,
- bei dem die erste Diffusionsbarriereschicht (6) unter Verwendung des mindestens zwei Schichten umfassenden Mehrlagenfotolacksystems strukturiert wird,
- bei dem ganzflächig eine erste dotierte Schicht (11) abgeschieden wird, die als Diffusionsquelle geeignet ist,
- bei dem ein erstes Diffusionsgebiet (110) durch Ausdiffusions aus der ersten dotierten Schicht (11) gebildet wird, wobei die strukturierte erste Diffusionsbarriereschicht (6) unter der ersten dotierten Schicht (11) als Maske wirkt,
- bei dem nach Bildung des ersten Diffusionsgebietes (110) die erste dotierte Schicht (11) entfernt wird,
- bei dem ganzflächig eine zweite Diffusionsbarriereschicht (12) aufgebracht wird,
- bei dem die zweite Diffusionsbarriereschicht (12) und die darunter liegende erste Diffusionsbarriereschicht (6) unter Verwendung eines mindestens zwei Schichten umfassenden Mehrlagenfotolacksystems strukturiert wird,
- bei dem ganzflächig eine zweite dotierte Schicht (17) abgeschieden wird, die vom entgegengesetzten Leitfähigkeitstyp zur ersten dotierten Schicht (11) dotiert ist und die als Diffusionsquelle geeignet ist,
- bei dem ein zweites Diffusionsgebiet (170) durch Ausdiffusion aus der zweiten dotierten Schicht (17) gebildet wird, wobei die strukturierte zweite Diffusionsbarriereschicht (12) unter der zweiten dotierten Schicht (17) als Maske wirkt.

3. Verfahren nach Anspruch 2,
- bei dem vor dem Aufbringen der zweiten Diffusionsbarriereschicht (12) die strukturierte erste Diffusionsbarriereschicht (6) entfernt wird,
- bei dem nur die zweite Diffusionsbarriereschicht (12) strukturiert wird.

4. Verfahren nach einem der Ansprüche 1 bis 3,
- bei dem für die Bottomresistschicht (7, 13) ein Fotolack auf Diazochinon/Novolak-Basis verwendet wird,
- bei dem für die Topresistschicht (8, 14) ein siliziumhaltiges Terpolymer, das aus den monomeren Maleinanhydrid, Allyltrimethylsilan und Maleinimid aufgebaut ist, verwendet wird.

5. Verfahren nach einem der Ansprüche 1 bis 4,
bei dem die Topresistschicht nach der Entwicklung mit einem Aminosiloxan silyliert wird.

6. Verfahren nach einem der Ansprüche 1 bis 5,
bei dem die Bottomresistschicht (7, 13) in einem O₂-Plasma strukturiert wird.

7. Verfahren nach einem der Ansprüche 1 bis 6,
bei dem die Diffusionsbarriereschichten (6, 12) mindestens eines der Materialien SiO₂ oder Si₃N₄ enthalten.

8. Verfahren nach einem der Ansprüche 1 bis 7,
bei dem die dotierten Schichten (11, 17) aus dotiertem polykristallinem oder amorphem Silizium oder aus dotiertem Glas gebildet werden.

9. Verfahren nach einem der Ansprüche 1 bis 8,
- bei dem als Substrat ein SOI-Substrat mit einer monokristallinen Siliziumschicht (3), einer darunter angeordneten isolierenden Schicht (2) und einer darunter angeordneten monokristallinen Siliziumscheibe (1) verwendet wird,
- bei dem der Graben (51, 52) durch die monokristaline Siliziumschicht (3) hindurch bis auf die isolierende Schicht (2) reicht,
- bei dem die Diffusionsgebiete (110, 170) in der monokristallinen Schicht (3) gebildet werden.

## Claims

1. Process for producing at least one diffusion region adjacent to a recess in a substrate,
- in which at least one recess (51) which extends essentially perpendicularly to the surface of the substrate (1, 2, 3) is etched into the substrate (1, 2, 3), which has silicon at least on the surface,
- in which a diffusion barrier layer (6) is applied over the entire surface,
- in which the diffusion barrier layer (6) is structured using a multi-layer photoresist system comprising at least two layers (7, 8),
- in which, for structuring the diffusion barrier layer (6), a bottom resist layer (7) which is made opaque by baking out is applied,
- in which a top resist layer (8) which is illuminated and developed is applied,
- in which the bottom resist layer (7) is etched in an anisotropic dry etching process using the developed top resist layer (8, 10) as a mask,
- in which the bottom resist layer (7) and the top resist layer (8) are removed after the diffusion barrier layer (6) has been structured,
- in which a doped layer (11) which is suitable as a diffusion source is deposited over the entire surface,
- in which the diffusion region (110) is formed by diffusion out from the doped layer (11), the structured diffusion barrier layer (6) under the doped layer (11) acting as a mask.

2. Process according to Claim 1,
- in which a first diffusion barrier layer (6) is applied over the entire surface,
- in which the first diffusion barrier layer (6) is structured using the multi-layer photoresist system comprising at least two layers,
- in which a first doped layer (11) which is suitable as a diffusion source is deposited over the entire surface,
- in which a first diffusion region (110) is formed by diffusion out from the first doped layer (11), the structured first diffusion barrier layer (6) under the first doped layer (11) acting as a mask,
- in which the first doped layer (11) is removed after the first diffusion region (110) has been formed,
- in which a second diffusion barrier layer (12) is applied over the entire surface,
- in which the second diffusion barrier layer (12) and the underlying first diffusion barrier layer (6) are structured using a multi-layer photoresist system comprising at least two layers,
- in which a second doped layer (17), which is doped with the opposite conductivity type to the first doped layer (11) and is suitable as a diffusion source, is deposited over the entire surface,
- in which a second diffusion region (170) is formed by diffusion out from the second doped layer (17), the structured second diffusion barrier layer (12) under the second doped layer (17) acting as a mask.

3. Process according to Claim 2,
- in which the structured first diffusion barrier layer (6) is removed before the second diffusion barrier layer (12) is applied,
- in which only the second diffusion barrier layer (12) is structured.

4. Process according to one of Claims 1 to 3,
- in which a photoresist based on diazoquinone/Novolak is used for the bottom resist layer (7, 13),
- in which a silicon-containing terpolymer, which is made of the monomers maleic anhydride, allyltrimethylsilane and maleimide, is used for the top resist layer (8, 14).

5. Process according to one of Claims 1 to 4, in which the top resist layer is silylated with an aminosiloxane after development.

6. Process according to one of Claims 1 to 5, in which the bottom resist layer (7, 13) is structured in an O₂ plasma.

7. Process according to one of Claims 1 to 6, in which the diffusion barrier layers (6, 12) contain at least one of the materials SiO₂ or Si₃N₄.

8. Process according to one of Claims 1 to 7, in which the doped layers (11, 17) are formed from doped polycrystalline or amorphous silicon or from doped glass.

9. Process according to one of Claims 1 to 8,
- in which an SOI substrate, with a monocrystalline silicon layer (3), an insulating layer (2) arranged underneath and a monocrystalline silicon wafer (1) arranged under the latter, is used as the substrate,
- in which the recess (51, 52) extends through the monocrystalline silicon layer (3) as far as the insulating layer (2),
- in which the diffusion regions (110, 170) are formed in the monocrystalline layer (3).

## Revendications

1. Procédé pour réaliser au moins un domaine de diffusion voisin d'une tranchée dans un substrat,
- dans lequel on grave dans le substrat (1, 2, 3), qui comporte du silicium au moins en surface, au moins une tranchée (51) qui s'étend sensiblement perpendiculairement à la surface du substrat (1, 2, 3),
- dans lequel on applique sur toute la surface une couche barrière de diffusion (6),
- dans lequel la couche barrière de diffusion (6) est structurée par utilisation d'un système de vernis photosensible multicouche, comportant au moins deux couches (7, 8),
- dans lequel, pour structure la couche barrière de diffusion (6), on applique une couche de réserve inférieure (7) qui par chauffage est rendue opaque à la lumière,
- dans lequel on applique une couche de réserve inférieure (8), qui est exposée à la lumière et développée,
- dans lequel, par utilisation de la couche de réserve supérieure développée (8, 10) en tant que masque, on grave la couche de réserve inférieure (7) dans une opération de gravure sèche anisotrope,
- dans lequel, après structuration de la couche barrière de diffusion (6), on enlève la couche de réserve inférieure (7) et la couche de réserve supérieure (8),
- dans lequel on dépose sur toute la surface une couche dopée (11) qui peut servir de source de diffusion,
- dans lequel le domaine de diffusion (110) est formé par diffusion à partir de la couche dopée (11), la couche barrière de diffusion structurée (6) disposée en-dessous de la couche dopée (11) servant de masque.

2. Procédé selon la revendication 1,
- dans lequel on applique sur toute la surface une première couche barrière de diffusion (6),
- dans lequel la première couche barrière de diffusion (6) est structurée par utilisation du système de vernis photosensible multicouche comportant au moins deux couches,
- dans lequel on dépose sur toute la surface une première couche dopée (11) qui va servir de source de diffusion,
- dans lequel un premier domaine de diffusion (110) est formé par diffusion à partir d'une première couche dopée (11), la première couche barrière de diffusion structurée (6), disposée en-dessous de la première couche dopée (11), servant de masque,
- dans lequel, après formation du premier domaine de diffusion (110), on enlève la première couche dopée (11),
- dans lequel on applique sur toute la surface une deuxième couche barrière de diffusion (12),
- dans lequel la deuxième couche barrière de diffusion (12) et la première couche barrière de diffusion (6) disposée en-dessous sont structurées par utilisation d'un système de vernis photosensible multicouche, comportant au moins deux couches,
- dans lequel on dépose sur toute la surface une deuxième couche dopée (17), dont le dopage présente un type de conductivité opposé à celui de la première couche dopée (11), et qui peut servir de source de diffusion,
- dans lequel un deuxième domaine de diffusion (170) est formé par diffusion à partir de la deuxième couche dopée (17), la deuxième couche barrière de diffusion structurée (12) disposée en-dessous de la deuxième couche dopée (17) servant de masque.

3. Procédé selon la revendication 2,
- dans lequel, avant application de la deuxième couche barrière de diffusion (12), on enlève la première couche barrière de diffusion structurée (6),
- dans lequel seule est structurée la deuxième couche barrière de diffusion (12).

4. Procédé selon l'une des revendications 1 à 3,
- dans lequel on utilise pour la couche de réserve inférieure (7, 13) un vernis photosensible à base de diazoquinone-novolaque,
- dans lequel on utilise pour la couche de réserve supérieure (8, 14) un terpolymère contenant du silicium, constitué des monomères anhydride maléique, allyltriméthylsilane et maléimide.

5. Procédé selon l'une des revendications 1 à 4, dans lequel la couche de réserve supérieure est, après développement, silylée avec un aminosiloxane.

6. Procédé selon l'une des revendications 1 à 5, dans lequel la couche de réserve inférieure (7, 13) est structurée dans un plasma d'oxygène.

7. Procédé selon l'une des revendications 1 à 6, dans lequel les couches barrière de diffusion (6, 12) contiennent au moins l'un des matériaux SiO₂ ou Si₃N₄.

8. Procédé selon l'une des revendications 1 à 7, dans lequel les couches dopées (11, 17) sont constituées de silicium polycristallin ou amorphe dopé ou de verre dopé.

9. Procédé selon l'une des revendications 1 à 8,
- dans lequel on utilise en tant que substrat un substrat SSI comportant une couche de silicium monocristallin (3), une couche isolante (2) disposée en-dessous et une pastille de silicium monocristallin (1) disposé en-dessous,
- dans lequel la tranchée (51, 52) traverse la couche de silicium monocristallin (3) pour arriver à la couche isolante (2),
- dans lequel les domaines de diffusion (110, 170) sont formés dans la couche monocristalline (3).
